# EUROPÄISCHE PATENTSCHRIFT

(11) **EP 0 963 599 B1**
(45) Veröffentlichungstag und Bekanntmachung des Hinweises auf die Patenterteilung: **21.03.2007**
(21) Anmeldenummer: 98905311.1
(22) Anmeldetag: 19.01.1998
(51) Int. Cl.: H01L 21/306, H01L 21/00, B08B 3/00

(54) **VERFAHREN UND VORRICHTUNG ZUR REINIGUNG VON SUBSTRATOBERFLÄCHEN**
METHOD AND DEVICE FOR CLEANING SUBSTRATE SURFACES
PROCEDE ET DISPOSITIF POUR NETTOYER DES SURFACES D'UN SUBSTRAT

(30) Priorität: 22.01.1997 DE 19701971
(43) Veröffentlichungstag der Anmeldung: 15.12.1999
(73) Patentinhaber: Fraunhofer-Gesellschaft zur Förderung der angewandten Forschung e.V., 80686 München (DE); Invent GmbH - Entwicklung Neuer Technologien, 91080 Uttenreutheld (DE)
(72) Erfinder: GENENGER, Bernd, D-91077 Hetzles (DE); MESSMANN, Klaus, D-93049 Regensburg (DE)
(86) Internationale Anmeldenummer: PCT/EP1998/000261
(87) Internationale Veröffentlichungsnummer: WO 1998/033208

(56) Entgegenhaltungen:
- EP-A- 0 428 983
- EP-A- 0 561 458
- US-A- 4 749 640
- US-A- 5 378 317
- US-A- 5 567 244
- US-A- 5 571 367
- PATENT ABSTRACTS OF JAPAN vol. 12, no. 92 (C-483), 25.März 1988 & JP 62 226801 A (SHIODA), 5.Oktober 1987,

## Beschreibung

Die Erfindung betrifft ein Verfahren und eine Vorrichtung zur Reinigung von Substratoberflächen.

Ein Verfahren zur Reinigung von Substratoberflächen ist aus der US 5,464,480 der US 5,571,367 sowie der US 5, 378, 317 bekannt. Danach werden eine auf die Oberfläche eines Substrats, bsp. eines Silizium-wafers, aufgebrachte organische Fotolackschicht sowie andere organische Verunreinigungen durch Inkontaktbringen mit Ozon in wäßriger Lösung oxidiert und entfernt.

Die bekannten Verfahren haben den Nachteil, daß sie zeitaufwendig sind. Um dem entgegenzuwirken, wird nach der US 5,464,480 die Substratoberfläche mit Ozon in wäßriger Lösung in Kontakt gebracht, wobei die Lösung auf eine Temperatur von 1 - 15°C gekühlt wird. Dadurch wird die Löslichkeit des Ozons im Lösungsmittel erhöht, was wiederum eine Erhöhung der Reinigungsgeschwindigkeit bewirken soll. Dem wirkt aber die Temperaturerniedrigung der Lösung entgegen, die eine Verlangsamung der, Reaktionsgeschwindigkeit der Oxidationsreaktion bewirkt, so daß insgesamt keine bemerkenswerte Erhöhung der Reinigungsgeschwindigkeit erhielt wird. Ein weiterer Nachteil besteht darin, daß die an der Substratoberfläche anhaftenden organischen Substanzen mitunter nicht quantitativ entfernt werden. Das führt zu unerwünschten Fehlern bei der Herstellung von Strukturen auf der Substratoberfläche,

Nach der US 5,378,317 wird die Substratoberfläche vor dem Inkontaktbringen mit der ozonhaltigen Lösung mit gasförmigem Ozon umspült. Das bewirkt eine gewisse. Beschleunigung des Reinigungsvorgangs. Gleichwohl gewährleistet auch dieses Verfahren nicht immer eine quantitative Entfernung organischer Substanzen von der Substratoberfläche.

Die US 5, 454, 480 sowie die US 5,378,317 offenbaren darüber hinaus Vorrichtungen zur Durchführung der vorerwähnten Verfahren.

Eine Vorrichtung zur Reinigung von Substratoberflächen ist aus JP 4-177726 A2 bekannt. Desweiteren ist aus der US-Patentschrift 5,337,446 eine Reinigungsvorrichtung bekannt, bei der Ultraschallenergie angewendet wird. Die Vorrichtung umfaßt ein Druckgefäß, bei dem eine Reinigungsflüssigkeit unter Überdruck mit dem Substrat in Kontakt gebracht wird.

Darüber hinaus ist aus JP 6-292822 A2 ein Verfahren zur Herstellung einer wäßrigen Lösung mit hohem Ozongehalt bekannt . Ebenso offenbart JP 1-207190 A2 eine Vorrichtung zum Lösen von Ozon in Wasser.

Ein weiteres Verfahren zur Reinigung von Substratoberflächen ist aus der EP-A-0 428 983 bekannt. Bei diesem Verfahren wird eine zu reinigende Oberfläche in eine Reinigungsflüssigkeit eingebracht, und ein sich lösendes Gas wie beispielsweise ein Edelgas wird in der Reinigungsflüssigkeit bei einem hohen Druck gelöst. Der Druck in der Flüssigkeit wird spontan erniedrigt, wodurch die Bildung von Blasen einsetzt, welche die Verunreinigungen von der Oberfläche lösen.

Aufgabe der vorliegenden Erfindung ist es, ein Verfahren und eine geeignete Vorrichtung vorzuschlagen, mit dem/der die Nachteile des Stands der Technik beseitigt werden. Insbesondere soll ein Verfahren sowie eine Vorrichtung zur Reinigung von Substratoberflächen bereitgestellt werden, das/die eine Schnelle und quantitative Entfernung, insbesondere organischer Substanzen, von der Substratoberfläche ermöglicht bzw. ermöglichen.

Diese Aufgabe wird durch die Merkmale der Patentansprüche I und 11 gelöst. Zweckmäßige Weiterbildungen ergeben sich aus den Merkmalen der Patentansprüche 2 bis 10 sowie 12 bis 23.

Nach Maßgabe der Erfindung ist verfahrensseitig vorgesehen, daß das Substrat mit Ozon in wäßriger Lösung in Kontakt gebracht wird, wobei
a) die Lösung unter einem Überdruck mit Ozon weitgehend gesättigt und
b) während des Reinigunsvorgangs die unter dem Überdruck stehende Lösung mit dem Substrat in Kontakt gebracht wird.

Unter Überdruck wird der den Luftdruck übersteigende Druck verstanden.

Die Reaktionsgeschwindigkeit wird dadurch überraschenderweise wesentlich erhöht. Gleichzeitig erfolgt zuverlässig eine quantitative Entfernung organischer Substanzen von der Substratoberfläche.

Es hat sich als zweckmäßig erwiesen, daß der Überdruck zwischen 10⁴ und 9·10⁵ Pa (0,1 und 9 bar) beträgt. Besonders bevorzugt wird ein Überdruck von 4·10⁵ Pa (4 bar). In diesem Fall wird eine ausreichend verbesserte Reaktionsgeschwindigkeit erreicht, wobei zum Bau einer zur Durchführung des Verfahrens geeigneten Vorrichtung auf handelsübliche Komponenten zurückgegriffen werden kann. Zur Herstellung der unter Überdruck stehenden Lösung wird gasförmiges Ozon vorteilhafterweise auf den Überdruck verdichtet und in ein Lösungsmittel eingebracht. Als Lösungsmittel dient üblicherweise destilliertes Wasser. Zur Verdichtung des Ozons kann ein Membranverdichter und zur Einbringung des Ozon in das Lösungsmittel ein Blasensäulenreaktor verwendet werden.

Nach einer Weiterbildung wird die Lösung auf einer konstanten Arbeitstemperatur im Bereich von 5 - 25°C gehalten. Das ermöglicht eine besonders gute Reproduzierbarkeit des Reinigungseffekts. Insbesondere zur Erzielung einer quantitativen Entfernung oxidierter organischer Substanzen hat es sich als zweckmäßig erwiesen, die Lösung in einer turbulenten oder laminaren Strömung mit der Substratoberfläche in Kontakt zu bringen.

Um auch eine Entfernung unerwünschter metallischer verunreinigungen von der Substratoberfläche zu ermöglichen, kann das Lösungsmittel und/oder die Lösung mit Fluorwasserstoff versetzt werden.

Als besonders vorteilhaft hat es sich erwiesen, das Substrat vor dem Inkontaktbringen mit der Lösung mit gasförmigem Ozon zu umspülen. Das erhöht nochmals die Reinigungsgeschwidigkeit.

Um eine Umweltbelastung durch freiwerdendes Ozon zu auszuschließen, kann nach einer weiteren Ausgestaltung nach dem Inkontaktbringen der Lösung mit dem Substrat das Ozon aus der Lösung entfernt und durch Wärmezufuhr in Sauerstoff umgewandelt werden.

Nach der vorrichtungsseitigen Lösung ist ein verschließbarer Behälter zum Inkontaktbringen des Substrats mit Ozon in wäßriger Lösung vorgesehen, welcher ein Druckbehälter ist, in dem die Lösung während des Reinigungsvorgangs unter einem Überdruck mit dem Substrat in Kontakt bringbar ist, mit einer mit der im Druckbehälter aufgenommenen Lösung in Wirkverbindung bringbaren Einrichtung zur Erzeugung des Überdrucks, einer mit einem Lösungsmittel in Verbindung bringbaren Einrichtung zur Erzeugung des Ozons, sowie einer mit der Einrichtung zur Erzeugung des Ozons in Verbindung bringbaren Einrichtung zum Einbringen des Ozons in das Lösungsmittel.

Vorteilhafterweise ist der Druckbehälter für einen Betrieb bei einem Überdruck von mindestens 10⁴ Pa, vorzugsweise von4·10⁵ Pa ausgelegt. Die Einrichtung zur Erzeugung des Überdrucks kann einen Membranverdichter zur Verdichtung des gasförmigen Ozons aufweisen. Ferner ist die Einrichtung zum Einbringen des Ozons in das Lösungsmittel vorzugsweise ein Blasensäulenreaktor. Als Lösungsmittel wird vorteilhafterweise mehrfach destilliertes Wasser verwendet. Zur Herstellung des Ozons in wäßriger Lösung ist zweckmäßigerweise ein mit der Einrichtung zur Erzeugung von Ozon in Verbindung bringbarer Blasensäulenreaktor vorgesehen.

Die Vorrichtung kann ferner ein Mittel zur Einstellung einer konstanten Arbeitstemperatur der Lösung im Bereich von 5 - 25°C aufweisen. Nach einem weiteren Ausgestaltungsmerkmal handelt es sich dabei um einen regelbaren Wärmetauscher, der die durch den Druckbehälter zirkulierende Lösung auf einer vorgegebenen Temperatur hält.

Als besonders zweckmäßig hat es sich erwiesen, ein Mittel zur Erzeugung turbulenter Strömungen der Lösung an der Substratoberfläche vorzusehen. Dabei kann es sich um eine geeignete Pumpe handeln, welche zur Zirkulation der Lösung durch den Druckbehälter in eine damit verbundene Ringleitung eingeschaltet ist. Auch Ultraschall kann zur Unterstützung der Entfernung von oxidierter organischer Substanz von der Substratoberfläche verwendet werden.

Die Oxidation der an der Substratoberfläche anhaftenden organischen Substanz kann ferner durch eine Spülung des Druckbehälters mit Ozon unterstützt werden. Das Spülen des Druckbehälters mit gasförmigem Ozon ist vorrichtungsseitig nur dann möglich, wenn der Druckbehälter nicht mit Lösung geflutet ist.

Stromabwärts des Druckbehälters kann eine Einrichtung zur Abscheidung von Ozon aus der Lösung vorgesehen sein, die eine Heizeinrichtung zur Umwandlung von Ozon in Sauerstoff aufweist. So wird vermieden, daß Ozon an die Umgebung abgegeben wird.

Der Druckbehälter ist vorzugsweise aus Edelstahl hergestellt, wobei die Innenseite des Druckbehälters mit Polytetrafluorethylen beschichtet ist. Auch die den Druckbehälter, die Einrichtungen, das Mittel sowie den Blasensäulenreaktor verbindenden Rohrleitungen sind zweckmäßigerweise aus Edelstahl hergestellt, wobei deren Innenwände ebenfalls mit Polytetrafluorethylen beschichtet sind.

Nachfolgend wird ein Ausführungsbeispiel der Erfindung anhand der Zeichnung näher erläutert. Es zeigen
- Fig. 1: eine schematische Darstellung eines Druckbehälters und
- Fig. 2: einen schematischen hydraulischen Schaltplan unter Verwendung des in Fig. 1 gezeigten Druckbehälters.

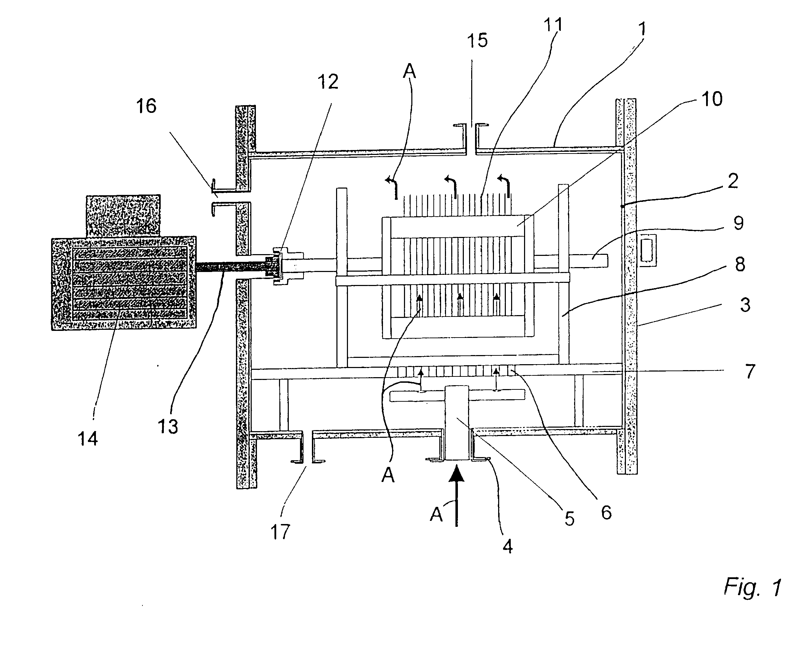

In Fig. 1 ist der Aufbau eines Druckbehälters schematisch im Querschnitt dargestellt. Der im Querschnitt gezeigte aus Edelstahl, wie V2A- oder V4A-Stahl, hergestellte Druckbehälter 1 ist an seiner Innenwand mit einer Polytetrafluorethylenschicht 2 versehen. Der Druckbehälter 1 ist mit einem abnehmbaren Deckel 3 gasdicht verschlossen. Am Boden des Druckbehälters 1 ist eine Öffnung mit einem ersten Rohrstutzen 4 mit einem Flansch zum Anschluß einer zuführenden Rohrleitung (hier nicht dargestellt) vorgesehen. Vom Inneren des Druckbehälters 1 her ist eine Tauchrohranordnung 5 in den ersten Rohrstutzen 4 eingesteckt. Oberhalb der Tauchrohranordnung 5 befindet sich ein mit Durchbrüchen.6 versehener Verteilerboden 7, auf dem eine Halterung 8 abgestützt ist. In der Halterung 8 ist eine um eine Achse 9 drehbare Aufnahme 10 für ein herausnehmbares Magazin (hier nicht gezeigt) zur Aufnahme von Halbleiter-Wafern 11, insbesondere Silizium-Wafern, gehaltert.

Die Achse 9 kann antriebsmäßig mittels einer Magnetkupplung 12 an eine außerhalb des Druckbehälters 1 vorgesehene Welle 13 angekuppelt werden. Die Welle 13 wird von einem Motor 14 angetrieben.

An der Oberseite des Druckbehälters 1 ist eine zweite Öffnung mit einem zweiten Rohrstutzen 15 mit einem Flansch zum Anschluß einer Überdruckarmatur (hier nicht gezeigt) vorgesehen. Mit 16 ist ein dritter Rohrstutzen zum Anschluß einer Überlaufleitung und mit 17 ein vierter Rohrstutzen zum Anschluß einer Ablaufleitung bezeichnet. Der Weg der zugeführten Medien, wie gasförmiges Ozon oder Ozon in wässriger Lösung, ist durch die Pfeile A kenntlich gemacht.

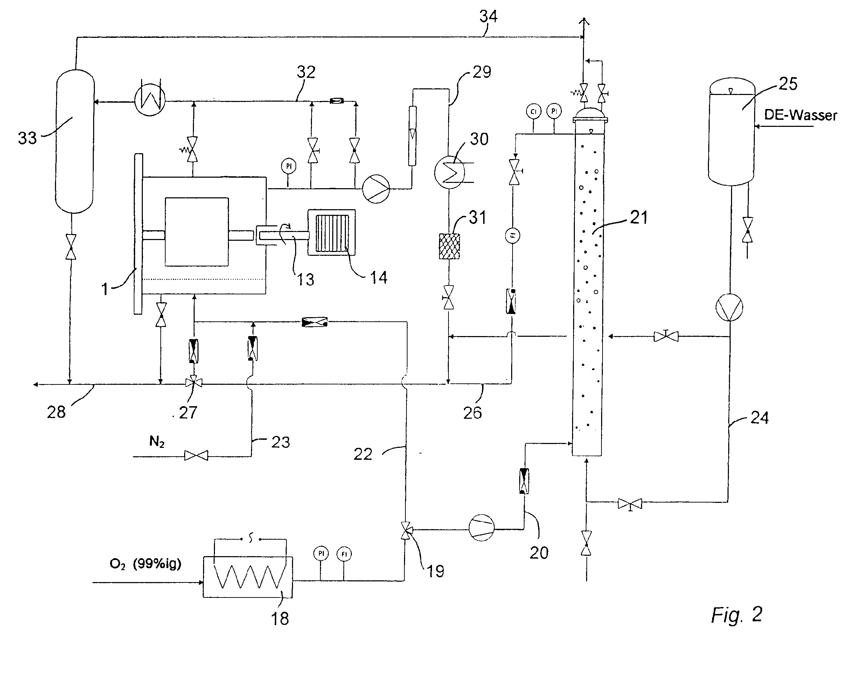

Fig. 2 zeigt einen hydraulischen Schaltplan einer erfindungsgemäßen Vorrichtung. Ein Ozongenerator 18 ist mittels eines ersten 3-Wege-Sperrventils 19 wahlweise mit einer in einen Blasensäulenreaktor 21 mündenden ersten Zuführleitung 20 oder direkt mit dem Druckbehälter 1 verbindbar. In den zum Druckbehälter 1 führenden Leitungsast 22 mündet eine absperrbare, gasförmigen Stickstoff führende Stickstoffleitung 23. Eine zweite Zuführleitung 24 verbindet den Blasensäulenreaktor 21 mit einem Vorrat 25 an Reinstwasser, welches als Lösungsmittel dient. Der Blasensäulenreaktor 21 ist über ein in eine Speiseleitung 26 eingeschaltetes zweites 3-Wege-Sperrventil 27 wahlweise mit dem Druckbehälter 1 oder einer Abflußleitung 28 verbindbar. Eine mit dem Druckbehälter 1 verbundene Rücklaufleitung 29, in welche ein Wärmetauscher 30 und ein Filter 31 nacheinander eingeschaltet sind, mündet in die Speiseleitung 26. Von der Rücklaufleitung 29 zweigt eine absperrbare Abführleitung 32 ab, die mit einem Gasabscheider 33 verbunden ist. Eine Gasabführleitung 34, die mit dem Blasensäulenreaktor 21 verbunden ist, führt zu einem (hier nicht dargestellten) Ozonvernichter.

Die Funktion der Vorrichtung ist folgende:
Im Ozongenerator 18 wird eingeleiteter Sauerstoff in Ozon umgewandelt. Das gasförmige Ozon wird in einem ersten Reinigungsschritt direkt via den Leitungsast 22 in den Druckbehälter 1 eingeleitet. Das Ozon umspült dort die darin befindlichen Halbleiter-Wafer. Organische Substanzen, wie ein Fotolack, werden durch das Umspülen mit dem gasförmigen Ozon weitgehend oxidiert und z.T. entfernt.

In einem zweiten Reinigungsschritt wird die Zufuhr gasförmigen Ozons zum Druckbehälter 1 durch Betätigung des ersten 3-Wege-Sperrventils 19 unterbrochen. Im Blasensäulenreaktor 21 wird über die erste Zuführleitung 20 zugeführtes gasförmiges Ozon mit über die zweite Zufuhrleitung 24 zugeführtem Reinstwasser zur Herstellung der Lösung in Kontakt gebracht. Dabei herrscht vorzugsweise ein Absolutdruck von etwa 5·10⁵ Pa (5 bar). Der Druckbehälter 1 wird über die Speiseleitung 26 mit der Lösung geflutet und ebenfalls mit einem Absolutdruck von 5·10⁵ Pa (5 bar) beaufschlagt. Danach wird die Lösung über die Rücklaufleitung 29 durch den Druckbehälter 1 zirkuliert, wobei die Halbleiter-Wafer turbulent umspült werden. Dadurch werden sämtliche organischen Substanzen oxidiert und von der Oberfläche der Halbleiter-Wafer entfernt. Die Verunreinigungen werden der Lösung mittels des Filter 31 entzogen. Der Lösung kann zur Entfernung beispielsweise metallischer Verunreinigungen von der Oberfläche der Halbleiter-Wafer zusätzlich Schwefelsäure und/oder Fluorwasserstoff zugesetzt werden. Auch ein Zusatz von Wasserstoffperoxid ist denkbar.

Nach der Durchführung des zweiten Reinigungsschritts wird die Lösung über die Abführleitung 32 in den Gasabscheider 33 abgeleitet. Das dort abgeschiedene Ozon gelangt über die Gasabführleitung 34 in einen (hier nicht dargestellten) Ozonvernichter. Der wässrige Rückstand wird über die Abflußleitung 28, ggf. nach einer Neutralisation, an die Kanalisation entsorgt.

Zur Trocknung der gereinigten Halbleiter-Wafer wird nun der Druckbehälter 1 mit Stickstoff gespült.

Die Halbleiter-Wafer werden während der Reinigungs- und Trocknungsschritte rotiert, um einen gleichmäßigen Kontakt mit den den Druckbehälter 1 durchströmenden Medien zu gewährleisten.

Bezugszeichenliste

| | |
|---|---|
| 1 | Druckbehälter |
| 2 | Polytetrafluorethylenschicht |
| 3 | Deckel |
| 4 | erster Rohrstutzen |
| 5 | Tauchrohranordnung |
| 6 | Durchbruch |
| 7 | Verteilerboden |
| 8 | Halterung |
| 9 | Achse |
| 10 | Aufnahme |
| 11 | Substrat |
| 12 | Magnetkupplung |
| 13 | Welle |
| 14 | Motor |
| 15 | zweiter Rohrstutzen |
| 16 | dritter Rohrstutzen |
| 17 | vierter Rohrstutzen |
| 18 | Ozongenerator |
| 19 | erstes 3-Wege-Sperrventil |
| 20 | erste Zuführleitung |
| 21 | Blasensäulenreaktor |
| 22 | Leitungsast |
| 23 | Stickstoffleitung |
| 24 | zweite Zuführleitung |
| 25 | Vorrat |
| 26 | Speiseleitung |
| 27 | zweites 3-Wege-Sperrventil |
| 28 | Abflußleitung |
| 29 | Rücklaufleitung |
| 30 | Wärmetauscher |
| 31 | Filter |
| 32 | Abführleitung |
| 33 | Gasabscheider |
| 34 | Gasabführleitung |

## Patentansprüche

1. Verfahren zur Reinigung von Substratoberflächen, bei dem das Substrat (11) mit Ozon in wässriger Lösung in Kontakt gebracht wird,
**dadurch gekennzeichnet, dass**
die Lösung unter einem Überdruck mit Ozon weitgehend gesättigt ist und während des Reinigungsvorgangs die unter dem Überdruck stehende Lösung mit dem Substrat (11) in Kontakt gebracht wird.

2. Verfahren nach Anspruch 1, wobei der Überdruck mindestens 10⁴Pa (0,1 bar) vorzugsweise höchstens 4·10⁵Pa (4 bar) beträgt.

3. Verfahren nach Anspruch 1 oder 2, wobei zur Herstellung der unter Überdruck stehen-den Lösung gasförmiges Ozon auf den Überdruck verdichtet und in ein Lösungsmittel eingebracht wird.

4. Verfahren nach Anspruch 3, wobei zur Verdichtung des Ozons ein Membranverdichter verwendet wird.

5. Verfahren nach Anspruch 3 oder 4, wobei zur Einbringung des Ozons in das Lösungsmittel ein Blasensäulenreaktor (21) verwendet wird.

6. Verfahren nach einem der vorhergehenden Ansprüche, wobei die Lösung auf einer konstanten Arbeitstemperatur im Bereich von 5 bis 25°C gehalten wird.

7. Verfahren nach einem der vorhergehenden Ansprüche, wobei die Lösung in einer turbulenten oder laminaren Strömung mit der Substratoberfläche in Kontakt gebracht wird.

8. Verfahren nach einem der vorhergehenden Ansprüche, wobei das Lösungsmittel und/ oder die Lösung mit Fluorwasserstoff versetzt wird/werden.

9. Verfahren nach einem der vorhergehenden Ansprüche, wobei das Substrat (11) vor dem Inkontaktbringen mit der Lösung mit gasförmigem Ozon umspült wird.

10. Verfahren nach einem der vorhergehenden Ansprüche, wobei nach dem Inkontaktbringen der Lösung mit dem Substrat (11) das Ozon aus der Lösung entfernt und durch Wärmezufuhr in Sauerstoff umgewandelt wird.

11. Vorrichtung zur Reinigung von Substratoberflächen, wobei ein verschließbarer Behälter vorgesehen ist, welcher ein Druckbehälter (1) ist, in dem die Lösung während des Reinigungsvorgangs unter einem Überduck mit dem Substrat (11) in Kontakt bringbar ist, mit einer mit der im Druckbehälter (1) aufgenommenen Lösung in Wirkverbindung bringbaren Einrichtung zur Erzeugung des Überdrucks,
**dadurch gekennzeichnet, dass**
der Druckbehälter (1) zum Inkontaktbringen des Substrats (11) mit Ozon in wäßriger Lösung geeignet ist, eine mit einem Lösungsmittel in Verbindung bringbare Einrichtung (18) zur Erzeugung von Ozon, sowie eine mit der Einrichtung zur Erzeugung des Ozons in Verbindung bringbare Einrichtung zum Einbringen des Ozons in das Lösungsmittel vorgesehen sind

12. Vorrichtung nach Anspruch 11, wobei der Druckbehälter (1) für einen Betrieb bei einem Überdruck von mindestens 10⁴ Pa (0,1 bar), vorzugsweise von 4·10⁵ Pa (4 bar), ausgelegt ist.

13. Vorrichtung nach Anspruch 11 oder 12, wobei die Einrichtung zur Erzeugung des Überdrucks einen Membranverdichter zur Verdichtung gasförmigen Ozons aufweist.

14. Vorrichtung nach einem der Ansprüche 11 bis 13, wobei die Einrichtung zum Einbringen des Ozons in das Lösungsmittel ein Blasensäulenreaktor ist.

15. Vorrichtung nach einem der Ansprüche 11 bis 14, wobei ein Mittel (30) zur Einstellung einer konstanten Arbeitstemperatur der Lösung im Bereich von 5 bis 25°C vorgesehen ist.

16. Vorrichtung nach einem der Ansprüche 11 bis 15, wobei ein Mittel zur Erzeugung einer turbulenten Strömung der Lösung an der Substratoberfläche vorgesehen ist.

17. Vorrichtung nach einem der Ansprüche 11 bis 16, wobei stromabwärts des Druckbehälters (1) eine Einrichtung (33) zur Abscheidung von Ozon aus der Lösung vorgese-hen ist.

18. Vorrichtung nach Anspruch 17, wobei die Einrichtung (33) zur Abscheidung eine Heizeinrichtung zur Umwandlung von Ozon in Sauerstoff aufweist.

19. Vorrichtung nach einem der Ansprüche 11 bis 18, wobei der Druckbehälter (1) aus Edelstahl hergestellt ist.

20. Vorrichtung nach einem der Ansprüche 11 bis 19, wobei die Innenseite des Druckbehälters (1) mit Polytetrafluorethylen (2) beschichtet ist.

21. Vorrichtung nach einem der Ansprüche 11 bis 20, wobei der Druckbehälter (1), die Einrichtungen (18, 33), das Mittel (30) sowie der Blasensäulenreaktor (21) durch Rohrleitungen verbunden sind, deren Innenwände mit Polytetrafluorethylen beschichtet sind.

## Claims

1. Method for cleaning substrate surfaces, in which the substrate (11) is brought into contact with ozone in an aqueous solution, **characterized in that** the solution is largely saturated under a positive pressure with ozone and, during the cleaning operation, the positively pressurized solution is brought into contact with the substrate (11).

2. Method according to Claim 1, the positive pressure being at least 10⁴ Pa (0.1 bar), preferably at most 4·10⁵ Pa (4 bar).

3. Method according to Claim 1 or 2, gaseous ozone being compressed to the positive pressure and being introduced into a solvent in order to produce the positively pressurized solution.

4. Method according to Claim 3, a diaphragm-type compressor being used to compress the ozone.

5. Method according to Claim 3 or 4, a bubble column reactor (21) being used to introduce the ozone into the solvent.

6. Method according to one of the preceding claims, the solution being kept at a constant operating temperature in the region of 5 to 25°C.

7. Method according to one of the preceding claims, the solution being brought into contact with the substrate surface in a turbulent or laminar flow.

8. Method according to one of the preceding claims, the solvent and/or the solution being mixed with hydrogen fluoride.

9. Method according to one of the preceding claims, the substrate (11) being swept over with gaseous ozone before being brought into contact with the solution.

10. Method according to one of the preceding claims, where, after the solution is brought into contact with the substrate (11), the ozone is removed from the solution and is converted into oxygen by heat being supplied.

11. Device for cleaning substrate surfaces, a closable container which is an autoclave (1) being provided, in which, during the cleaning operation, the solution can be brought under a positive pressure into contact with the substrate (11), with an apparatus which can be brought into operative connection with the solution held in the autoclave (1) and which is intended for generating the positive pressure, **characterized in that** the autoclave (1) is suitable for bringing the substrate (11) into contact with ozone in an aqueous solution, and an apparatus (18) which can be brought into connection with a solvent and which is intended for generating ozone, and an apparatus which can be brought into connection with the apparatus for generating the ozone and is intended for introducing the ozone into the solvent are provided.

12. Device according to Claim 11, the autoclave (1) being configured for operation at a positive pressure of at least 10⁴ Pa (0.1 bar), preferably of 4·10⁵ Pa (4 bar).

13. Device according to Claim 11 or 12, the apparatus for generating the positive pressure having a diaphragm-type compressor for compressing gaseous ozone.

14. Device according to one of Claims 11 to 13, the apparatus for introducing the ozone into the solvent being a bubble column reactor.

15. Device according to one of Claims 11 to 14, a means (30) being provided for setting a constant operating temperature of the solution in the region of 5 to 25°C.

16. Device according to one of Claims 11 to 15, a means being provided for generating a turbulent flow of the solution at the substrate surface.

17. Device according to one of Claims 11 to 16, an apparatus (33) for extracting ozone from the solution being provided downstream of the autoclave (1).

18. Device according to Claim 17, the extraction apparatus (33) having a heating apparatus for converting ozone into oxygen.

19. Device according to one of Claims 11 to 18, the autoclave (1) being produced from high-grade steel.

20. Device according to one of Claims 11 to 19, the inside of the autoclave (1) being coated with polytetrafluoroethylene (2).

21. Device according to one of Claims 11 to 20, the autoclave (1), the apparatuses (18, 33), the means (30) and the bubble column reactor (21) being connected by pipes, the inner walls of which are coated with polytetrafluoroethylene.

## Revendications

1. Procédé de nettoyage de surfaces d'un substrat, en mettant le substrat (11) en contact avec de l'ozone en solution aqueuse,
**caractérisé en ce que**
la solution est largement saturée en ozone sous surpression et, pendant le processus de nettoyage, la solution en surpression est mise en contact avec le substrat (11).

2. Procédé selon la revendication 1, dans lequel la surpression s'élève à au moins 10⁴ Pa (0,1 bar), de préférence à au plus 4·10⁵ Pa (4 bars).

3. Procédé selon la revendication 1 ou 2, dans lequel on comprime de l'ozone gazeux à la surpression et on l'incorpore dans un solvant pour fabriquer la solution sous surpression.

4. Procédé selon la revendication 3, dans lequel on utilise un compresseur à membrane pour comprimer l'ozone.

5. Procédé selon la revendication 3 ou 4, dans lequel on utilise un réacteur à colonne à bulles (21) pour incorporer l'ozone dans le solvant.

6. Procédé selon l'une quelconque des revendications précédentes, dans lequel on maintient la solution à une température de travail constante de l'ordre de 5 à 25°C.

7. Procédé selon l'une quelconque des revendications précédentes, dans lequel on met la solution en contact avec la surface du substrat dans un écoulement turbulent ou laminaire.

8. Procédé selon l'une quelconque des revendications précédentes, dans lequel on ajoute du fluorure d'hydrogène au solvant et/ou à la solution.

9. Procédé selon l'une quelconque des revendications précédentes, dans lequel on rince le substrat (11) avec de l'ozone gazeux avant la mise en contact avec la solution.

10. Procédé selon l'une quelconque des revendications précédentes, dans lequel on élimine l'ozone de la solution et on le transforme en oxygène en apportant de la chaleur après avoir mis la solution en contact avec le substrat (11).

11. Dispositif de nettoyage de surfaces d'un substrat avec un récipient sous pression (1) pouvant être fermé, dans lequel on peut mettre la solution sous surpression en contact avec le substrat (11) pendant le processus de nettoyage, et qui comporte un dispositif pouvant être mis en liaison active avec la solution recueillie dans le récipient sous pression (1) afin de produire la surpression,
**caractérisé en ce que**
le récipient sous pression (1) convient pour la mise en contact du substrat (11) avec l'ozone en solution aqueuse, et pour la production d'ozone un dispositif (18) peut être mis en liaison avec un solvant, et on relie à ce dispositif de production d'ozone, un dispositif d'introduction d'ozone dans le solvant.

12. Dispositif selon la revendication 11, dans lequel le récipient sous pression (1) est conçu pour fonctionner à une surpression d'au moins 10⁴ Pa (0,1 bar), de préférence de 4·10⁵ Pa (4 bars).

13. Dispositif selon la revendication 11 ou 12, dans lequel le dispositif de production de la surpression présente un compresseur à membrane pour comprimer l'ozone gazeux.

14. Dispositif selon l'une quelconque des revendications 11 à 13, dans lequel le dispositif d'introduction de l'ozone dans le solvant est un réacteur à membrane.

15. Dispositif selon l'une quelconque des revendications 11 à 14, dans lequel on prévoit un moyen (30) pour régler une température de travail constante de la solution de l'ordre de 5 à 25°C.

16. Dispositif selon l'une quelconque des revendications 11 à 15, dans lequel on prévoit un moyen de production d'un écoulement turbulent de la solution à la surface du substrat.

17. Dispositif selon l'une quelconque des revendications 11 à 16, dans lequel on prévoit, en aval du récipient sous pression (1), un dispositif (33) pour séparer l'ozone de la solution.

18. Dispositif selon la revendication 17, dans lequel le dispositif (33), pour procéder à la séparation, présente un dispositif de chauffage qui transforme l'ozone en oxygène.

19. Dispositif selon l'une quelconque des revendications 11 à 18, dans lequel le récipient sous pression (1) est en acier spécial.

20. Dispositif selon l'une quelconque des revendications 11 à 19, dans lequel le côté intérieur du récipient sous pression (1) est recouvert de polytétrafluoréthylène (2).

21. Dispositif selon l'une quelconque des revendications 11 à 20, dans lequel le récipient sous pression (1), les dispositifs (18, 33), le moyen (30) ainsi que le réacteur à colonne à bulles (21) sont reliés par des tuyauteries dont les parois intérieures sont recouvertes de polytétrafluoréthylène.
